Europäisches Patentamt

European Patent Office

Office européen des brevets

(19)

(11) EP 0 595 379 B1

(12) **EUROPEAN PATENT SPECIFICATION**

(45) Date of publication and mention
of the grant of the patent:
**20.11.2002 Bulletin 2002/47**

(51) Int Cl.[7]: **G01R 31/28**, G06F 11/26

(21) Application number: **93202539.8**

(22) Date of filing: **31.08.1993**

(54) **A method and apparatus for analog test signal usage in a digital environment**

Verfahren und Vorrichtung zur Verwendung analoger Testsignale in digitaler Umgebung

Procédé et dispositif d'utilisation de signaux de test analogiques dans un environnement numérique

(84) Designated Contracting States:
**DE FR GB IT**

(30) Priority: **07.09.1992 EP 92202698**
**15.04.1993 EP 93201098**

(43) Date of publication of application:
**04.05.1994 Bulletin 1994/18**

(73) Proprietor: **Koninklijke Philips Electronics N.V.**
**5621 BA Eindhoven (NL)**

(72) Inventors:
• **Zwemstra, Taco**
**NL-5656 AA Eindhoven (NL)**
• **Seuren, Gerardus Petrus Helena**
**NL-5656 AA Eindhoven (NL)**

(74) Representative:
**Groenendaal, Antonius Wilhelmus Maria et al**
**INTERNATIONAAL OCTROOIBUREAU B.V.,**
**Prof. Holstlaan 6**
**5656 AA Eindhoven (NL)**

(56) References cited:
**GB-A- 2 195 185**

• **PATENT ABSTRACTS OF JAPAN vol. 14, no. 389 (P-1095) 22 August 1990 & JP-A-02 147 876 (MITSUBISHI ELECTRIC CORP) 6 June 1990**
• **IEEE JOURNAL OF SOLID-STATE CIRCUITS, vol.26, no.12, December 1991, NEW YORK US pages 1757 - 1762 B. M. J. KUP 'A bit-stream digital-to-analog converter with 18-b resolution'**
• **PROCEEDINGS INTERNATIONAL TEST CONFERENCE 1991, IEEE pages 1049 - 1054 D. ROSENTHAL 'A 20 bit waveform source for a mixed-signal automatic test system'**
• **PROCEEDINGS OF THE IEEE 1991 CUSTOM INTEGRATED CIRCUITS CONFERENCE, 12 - 15 MAY, SAN DIEGO US pages 13.5.1 - 13.5.4 M. JARWALA ET AL. 'A framework for design for testability of mixed analog/digital circuits'**
• **IEEE INSTRUMENTATION AND MEASUREMENT TECHNOLOGY CONFERENCE RECORD, 12 - 14 MAY 1992 NEW YORK US pages 514 - 517 A. R. EL-KOUBYSI ET AL. 'testing the performance of delta sigma ADCs'**

**Description**

FIELD OF THE INVENTION

The invention relates to a method as recited in the preamble of Claim 1. The invention also relates to an apparatus as recited in the preamble of Claim 4. The invention also relates to an electronic circuitry as recited in the preamble of claim 10.

a The standard according to reference GB-A 2,195,185 (A) is broadly accepted and in consequence, various hardware and software facilities have been developed for facilitating the use thereof. However, reference (A) relates exclusively to the testing of digital circuitry.

Testing analog circuitry, whether in isolation, or as part of mixed analog/digital circuitry is by contrast usually performed as functional testing, where the apparatus should execute a part of the intended standard functionality. The test signal is often generated by some sort of signal shaper, such as a sinusoid generator. Subsequently it is observed whether the circuit functionality appeared correct as detectable from some result signal. Such testing is relatively expensive and needs the generation of specific signals often produced by means of extremely versatile and expensive test machines. The inventors have recognized a need for allowing the usage of simplified and general purpose test machines while creatively using available digital techniques as far as possible.

Accordingly, amongst other things, it is an object of the present invention to provide a method and apparatus for testing an electronic circuitry arrangement that allows straightforward application of analog test patterns that may lend themselves to easy generation and storage. In consequence, amongst other things, the invention is characterized by the characterizing parts of Claims 1 and 4. The invention also relates to an arrangement according to Claim 10, which therefore accommodates at least of a **B**uilt-**I**n **S**elf-**T**est functionality

By itself, IEEE Journal of Solid-State Circuits, Vol. 26, 1991, no. 12, pages 1757-1762 (B) describes "A Bit-Stream Digital-to-Analog Converter with 18-b Resolution". However, (B) does not contemplate the environment of **testing** analog circuitry. Furthermore, Proceedings International Test Conference 1991, IEEE, paper 39.2, pages 1049-1054 (C) describes "A 20 Bit Waveform Source for a Mixed-Signal Automatic Test System", that is used for both ac and dc testing of analog to digital converters. In contradistinction, the present invention intends to test analog circuitry which is not restricted to having any particular functionality, through using digital signal streams as a vehicle for transfer, storage and the like, and to thereby allow the usage of digital test standards that have become commonplace throughout industry.

SUMMARY OF THE INVENTION

As stated above, amongst other things, it is an object of the present invention to provide a method for testing an electronic circuitry arrangement that allows straightforward application of analog test patterns that may lend themselves to easy generation and storage. Now, according to one of its aspects, the invention is defined in claim 1.

Advantageously, said modulating is first or second order sigma delta modulation. This way modulating is extremely straightforward, although other techniques would be feasible as well.

Advantageously, said extracting comprises a step of repeatedly discriminating an output wave result signal with successive threshold levels and subsequently realigning successive discrimination bit stream results for at respective instants generating a thermometer signal code. Again here, the analog interface part is extremely straightforward.

The invention also relates to an apparatus for testing an electronic circuitry arrangement according to the preamble and comprising in particular modulating means for modulating a parent signal to a digital bit stream and filtering means fed by said modulating means for producing said test signal through analog filtering of said digital bit stream as defined in claim 4. This proves a straightforward realization. By itself, the testing may be a boundary scan test or a self-test mechanism. Both these methodologies have proven feasible.

The invention also relates to an electronic circuitry arrangement as a target for executing the method supra, as defined in claim 10.

Such an electric circuitry arrangement, comprising test signal source means for generating a test signal, test signal input means for receiving the test signal, operating means fed by said test signal input means for in a predetermined operating mode operating on said test signal to produce a result signal of predetermined shape, and result signal output means for outputting said result signal for subsequent evaluation is known from the art.

Various advantageous aspects are recited in dependent Claims.

BRIEF DESCRIPTION OF THE DRAWING

These and other aspects and advantages of the invention will hereinafter be discussed in detail with respect to a preferred embodiment that in particular has been illustrated in and by the appended Figures that show:

| | |
|---|---|
| Figure 1 | an archetypical tester machine set-up; |
| Figure 2 | a schematic of a test signal generation technique; |
| Figure 3 | a general sigma-delta modulation; |
| Figures 4A, 4B | first and second order sigma-delta modulation; |
| Figure 5 | a comparator circuit as used on a digital tester; |
| Figure 6 | a comparator circuit as used for A/D conversion. |

## DETAILED DESCRIPTION OF PREFERRED EMBODIMENTS

Figure I shows an archetypical tester machine set-up, comprising a test signal generator 20, a device under test 22, and a result signal evaluator 24. The test signal generator produces a test signal, the device under test receives this signal and is subsequently controlled in a normal operating mode or other predetermined mode, and the result signal evaluator will from the result signal find out whether the device under test functions well. This qualification applies whether the test is by itself structural or functional. The result may indicate various qualifications, such as good, faulty, partially good, needs repair, but others are feasible as well, such as: operates correctly provided the clock frequency is less than XY MHz, or a particular qualification such as one indicating the signal to noise ratio. The device under test may be a single integrated circuit chip, a board with multiple chips, a wafer scale integrated circuit, or any other feasible package level. With respect to testing with digital signals, US 5 430 735 and US 5 657 329 provide ample detail, and in fact, the test procedure and also the test provisions on the circuitry under test may comply with the Boundary Scan Test Standard. Inter alia, this means serial data in pin, serial data out pin, test clock pin, and one or two extra pins for control signals.

The invention uses analog test signals to be applied to the device under test proper, such as sinusoids, multitone signals, and arbitrary waves, including block waves. The environment as described may be used to operate the circuitry arrangement with digital test signals as well, but this is not a restriction. Now, the test signal source block 20 may have one or more test signal output terminals in parallel, it may internally contain a memory for storing test patterns, it may have multiplexing means for multiplexing various test signals on a single output terminal, it may output control bit trains according to the Boundary Scan Test Standard, and other functions. For brevity, these provisions have not been shown, however. Also the providing of clock signals, such by a master clock, has not been shown. Also the initiation and the termination of the test have not been shown for brevity.

As to the dividing of the various tasks, a first possibility is that the analog signals are produced in part 28 of the test signal generator, as based on particular elements therein and on a stored digital bit pattern. A second possibility is that these analog test signals are produced in part 28 of the same package (board, chip, etc.) of the device under test. The latter option has been indicated in the drawing by an interrupted line 26 around device under test 22 that also encloses part 28. This means that only the digital representation of the analog test signal need be communicated from outside to the device under test. A further possibility is that substantially all of block 20 is contained in the same package, such as the integrated circuit chip, as the device under test itself. This would, as far as regards the applying of the test patterns, represent a self-test organization.

The invention also uses analog result signals that are derived from the device under test proper. In principle, such analog signals may be evaluated directly, for example by therefrom extracting a particular analog quantity, such as amplitude or frequency, etcetera as applicable, or by comparison with a model analog signal. For brevity, this has not been discussed further. A further type of evaluation first converts the analog signal to a bit stream, before evaluating. A first possibility is that this conversion takes place in part 30 of the result signal evaluator, as based on particular elements therein. A second possibility is that this conversion takes place in the same package (board, chip, etc.) of the device under test. The latter option has been indicated by drawing an interrupted line 26 around device under test 22 that also encloses part 30. This means that only the digital representation of the analog result signal need be communicated from the device under test to outside. As a further possibility, also the evaluation could be inside the circuitry. This would, as far as regards the outputting of the result patterns, represent a self-test organization.

In the exemplary embodiment, for governing the interaction between the three subsystems, block 20 has a control element 32 that operates as overall master. After transmission of the test signal has been completed, this element sends a control signal to control element 34 in block 22 for driving the latter in a normal state of operation, so that the test signal is effectively transformed into a result signal. Next, control element 32 activates a further control element 36 in block 24 that sets the latter to evaluating the result signal then received. The communication between the various control elements may be as required, and the assignment of the master functionality could be different. In a self-test scheme, all control may reside inside the circuitry under test. The whole test may be executed in a synchronous or asynchronous manner.

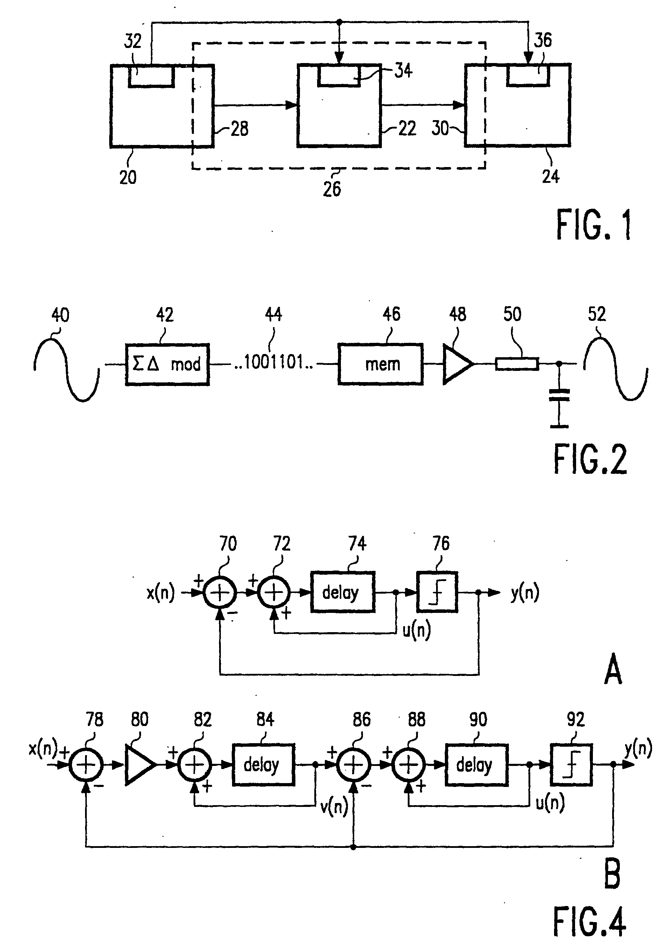

Figure 2 is a schematic of a test signal generation technique. Inter alia, this relates to the use of digital functionality in an unconventional and versatile way for generating analog test signals. This results in a compact test environment with minimal or no external equipment.

This technique is based on the observation that digital waveforms also embody analog signal content. They are adjusted to present desired signal characteristics, and are applied as an analog stimulus. One example of this is the generation of "noise" using digital data with desired statistical properties to detect significant device behaviour. Another candidate to achieve this is to modulate a desired analog signal onto a digital pulse train and to demodulate this signal at the output of a digital tester channel.

A modulation scheme which allows subsequent easy demodulation is 1-bit Sigma-Delta Modulation ($\Sigma\Delta$). An advantage of this scheme is its potential capability of achieving high performance test signals. This is because the process equals the conversion of a "perfect" test signal into a bitstream where the latter can be a high resolution representation of the first. Sigma-Delta modulation has been successfully applied for both A/D and D/A conversion. By itself, other modulation types are feasible as well as will be explained hereinafter.

As shown in Figure 2, a software model of the modulation process (42) converts a test signal (40) into e.g. a repeating or nearly repeating digital data-stream (44). When loaded into the tester's pin memory (46), this can then be applied with the required speed to a tester pin in a continuously repeating sequence.

Element 48 is a driver circuit. Next, recovering the original analog signal 52 can be accomplished by low-pass filtering the bitstream using a filter, e.g. a simple one or two section passive RC filter (50), which can be mounted on the test-board. The frequency of the signal can be controlled by the modulation characteristics and the test clock rate. The amplitude can simply be changed to a particular value by adjusting the voltage level of the digital pulse, or by changing the amplitude of the signal applied to the modulator circuitry 42.

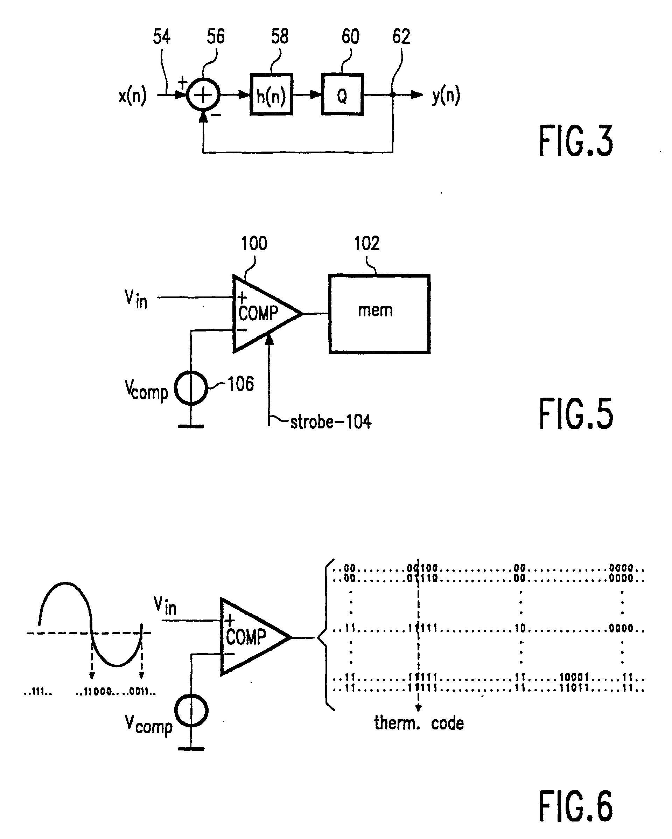

Next Figure 3 shows a general sigma-delta modulation. Generally, 1-bit Sigma-Delta modulation converts a sampled signal into a binary representation using a negative feedback system. It consists of a loop filter (58) h(n), a 1-bit quantizer Q (60) (a comparator for the 1-bit case) and a feedback (62, 56) which subtracts the quantized output y(n) from the input.

By itself, such systems have been described earlier, but the present invention expands their use to the field of analog testing.

In the conversion process a continuous input signal x(t) is oversampled at a rate $f_s = \frac{1}{T_s}$ much larger than the upper frequency of x(t). The difference between the sampled signal x(n) and the quantized output y(n) is converted to a 1-bit output code y(n) after filtering with the loop filter h(n), and subtracted from the next input sample. By the feedback loop the average digital output signal equals the average input signal as a sort of pulse density modulation. The oversampling and the loop filter or noise shaping filter spread the quantization noise over a large frequency band and shape the frequency content of the large quantization error such that most of its energy lies outside the signal or passband. The frequency spectrum of the bitstream y(n) contains the original signal and a quantization error spectrum with a high-pass character. The amount of in-band quantization noise power in relation to the signal spectrum determines the resolution or dynamic range of the converted analog signal.

Now, because of the high-pass character of the quantization noise the simplest possible demodulation to recover the original signal is analog low-pass filtering of the digital waveform. The combination of the digital tester to store the bitstream and a simple discrete analog filter is sufficient to generate high quality test signals.

There are various degrees of freedom in the above process, and their choice depends amongst others on the test signals required, i.e. frequency, resolution and type, the available tester frequency and the ease of analog filtering. In the modulation process in particular, the relevant parameters are the sample rate $f_s$ and the characteristics of the loop filter h(n). These determine the achievable dynamic range of the signal and impose requirements on the analog low-pass filter.

The achievable signal-to-noise-ratio(SNR) for converting a pure sinusoid of frequency $f_t$ within a frequency band $[0,f_b]$ through converting at rate $f_s = OSR. 2f_b$ followed by an ideal low-pass filter with cut off frequency $f_b$ is approximated by:

$$SNR = \frac{4}{\pi} \sqrt{\frac{3}{2}} \frac{\sqrt{2L + 1}}{\pi^L} (OSR)^{L+\frac{1}{2}} \qquad (1)$$

In this equation OSR is the oversampling ratio and L is the order of the noise shaping filter h(n).

Figures 4A, 4B show examples of first and second order sigma delta modulation, respectively. Figure 4A has a series arrangement of a subtraction element 70, an addition element 72, a delay element 74, and a low-pass filter 76, and provided with two feedback connections as shown. Its behaviour is given by the following difference equation:

$$u(n+1) = u(n) + x(n) - y(n).$$

Figure 4B has a series arrangement of a subtraction element 78, a buffer 80 with an attenuation factor of 0.5, an addition element 82, a delay element 84, a subtraction element 86, an addition element 88, a delay element 90, and a low-pass filter 92, and provided with three feedback connections as shown, of which one is coupled twice into the series arrangement. Its behaviour is given by the following difference equations:

$$v(n+1) = v(n) + 0.5(x(n) - y(n))$$

$$u(n+1) = u(n) + v(n) - y(n) \tag{3}$$

The quantizer behaviour is described in both cases as

$$y(n) = \begin{cases} 1 & \text{if } u(n) \geq 0 \\ -1 & \text{if } u(n) < 0 \end{cases} \tag{4}$$

These equations lend themselves well for implementation in a simple computer process, the output of which can be captured in a file (y(n) = 1 $\Rightarrow$ 1 and y(n) = -1 $\Rightarrow$ 0) and serve as data-file for the tester. For the situation where a continuous looping over a finite-length data record is used to generate the signal, it is important to acquire periodicity of the data stream for subsequent continuous looping. For sinewave generation this is resolved by an $\frac{M}{N}$ sampling

$$x(nT_s) = A\sin(2\pi f_t nT_s) = A\sin(2\pi n\frac{f_r}{f_s}) = A\sin(2\pi n\frac{M}{N}) \tag{5}$$

in which N samples are taken over M cycles of the sinusoid, thus guaranteeing periodicity in N for the sinewave signal alone. This does not imply that the data stream is periodic as well. Only in the case of first order coders this holds because then the quantization noise occurs in regular patterns and its spectrum is highly coloured. For higher order coders the quantization error tends to be more randomized, resulting in general in a non-periodic bitstream in N, i.e. one which does not repeat itself after N pulses. In order to use such higher order modulator models, one could use a data stream of finite length which contains a whole number of cycles of the original sinewave but not a repetitive noise pattern. Repeating this data stream in a continuous loop will cause the quantization noise pattern to repeat as well and thus it will be harmonically related to the sinewave frequency, resulting in a discrete quantization noise spectrum.

Another issue is the amplitude of the sinusoid. The general behaviour is an increase in achievable dynamic range for increasing amplitudes, up to a specific value where overload effects will occur resulting in deterioration of the resolution. Another effect are the oscillations which can occur in coders of order L > 1 under specific input conditions and which will limit the performance of the modulation process. Especially if the repetition frequency of such patterns is comparable to that of the input frequency, they will show up as distortion components in the frequency band of interest.

The following table expands the above to allow various decisions to be made in the design:

1. Data record must have finite length
1.1 Continuous looping of data record
1.1.1 This requires signals that are periodic in the length of the record, such as a single cycle of a sinusoid
1.1.1.1 M/N generates periodicity of analog signals
1.1.1.1.1 Quantized noise need not be periodic but is forced to be periodic
1.2 Single sweep of record (needs attention for setting behaviour of filter)
1.2.1 Periodic signals
1.2.1.1 Record may contain several cycles of the signal
1.2.1.2 Put together several records each containing one cycle of the signal
1.2.2 Non-periodic signals
1.2.2.1 If they are bandwidth limited some form of reconstruction may be achieved for approximately the intended signal shape.

Figure 5 shows a comparator circuit as used for comparing an analog signal with a reference signal, so that a binary output signal is produced that can be processed in a digital tester. Comparator 100 that receives the unknown

voltage $V_{in}$ and a reference voltage $V_{comp}$ as determined by some accessory circuit element 106. Furthermore, the comparator receives strobe signal 104 and outputs to memory 102. For brevity, further control mechanisms have not been shown. The reference voltage $V_{comp}$ is at a predetermined standard value somewhere between an intended high value and an intended low value, so that successive strobes will effect storage of a string of "ones" and "zeroes".

Figure 6 shows a comparator circuit as used for A/D conversion. By itself, the hardware corresponds to that of Figure 5. In effect, by means of a variable $V_{comp}$ a kind of serial A/D conversion is realized. The method is based on repeatedly sampling a one-bit digitized version of the analog signal for a particular value of $V_{comp}$. The compare voltage is now incremented by a number of discrete steps over the range of the analog signal, each step resulting in a one-bit acquisition. This yields a plurality of one/zero bit strings that have been depicted at the right hand side, after realigning with respect to each other. Each column indicates the analog signal value received at a particular instant, expressed as a linear thermometer code, that consists of a string of zeroes followed by a string of ones, the actual value of the analog signal being represented by the transition between the two strings. The latter code can be converted to binary, BCD, or other suitable code. The converter quality predominantly depends on the properties of the comparator, in particular its resolution, accuracy, overdrive quality and hysteresis. The unknown analog signal must be identically repeatable. Through the system described, hardly any further hardware is required.

## Claims

1. A method for testing an electronic circuitry arrangement (22), said method comprising the steps of:

   providing a test signal of predetermined shape to specific signal input means of the arrangement;
   operating said arrangement in a predetermined mode;
   extracting a result signal of intended shape from specific signal output means of said arrangement for subsequent evaluation of said result signal;

   said method being **characterized by** modulating a first analog signal (40) into a digital bit stream (44) and presenting said digital bit stream to subsequent filtering means (50) for through analog filtering out of said digital bit stream producing said test signal as a second analog signal (52) at an output of said filtering means.

2. A method as claimed in Claim 1, wherein said modulating is first or second order sigma delta modulation.

3. A method as claimed in Claim 1 or 2, wherein said extracting comprises a step of repeatedly discriminating an output wave result signal with successive threshold levels and subsequently realigning successive discrimination bit stream results for at respective instants generating a thermometer signal code.

4. An apparatus for testing an electronic circuitry arrangement (22), said apparatus comprising:

   test signal source means (20) for providing a test signal of predetermined shape to specific test signal input means of said arrangement;
   control means (32, 34) for operating said arrangement in a predetermined mode;
   extracting means (30) for extracting a result signal of intended shape from specific result signal output means of said arrangement for subsequent evaluation of said result signal;

   **characterized by** having modulating means (42) for modulating a first analog signal (40) into a digital bit stream (44) and filtering means (50) fed by said modulating means for through analog filtering out of said digital bit stream producing said test signal as a second analog signal (52) at an output of said filtering means.

5. An apparatus as claimed in Claim 4, wherein said test signal source means has digital storage means (46) for storing the digital bit stream as produced by said modulating means, and for subsequent presentation to said filtering means (50).

6. An apparatus as claimed in claim 4 or 5, wherein said modulating means are arranged for executing first or second order sigma delta modulation.

7. An apparatus as claimed in claims 4, 5 or 6, and comprising boundary scan test interfacing means for interfacing to said electronic circuitry arrangement.

8. An apparatus as claimed in any of claims 4 to 7, and being arranged for executing a selftest by means of having at least partially self-contained said test signal source and/or said evaluation means.

9. An apparatus as claimed in any of claims 4 to 8, wherein said extracting means (30) comprise a discriminating means for discriminating an output wave result signal with successive threshold levels and memory means fed by said extracting means for storing successive discrimination bit stream results for after realigning producing respective thermometer signal codes each associated to an analog signal outputted at a respective instant.

10. An electronic circuitry arrangement as a target for executing a method as claimed in Claim 1, and comprising test signal source means for generating a test signal, test signal input means for receiving the test signal, operating means fed by said test signal input means for in a predetermined operating mode operating on said test signal to produce a result signal of predetermined shape, and result signal output means for outputting said result signal for subsequent evaluation, wherein said test signal source means comprise digital storage means (46) for storing a digital bit stream derived from a first analog signal and filtering means (50) fed by said digital storage means for through analog filtering out of said digital bit stream producing said test signal as a second analog signal (52) at an output of said filtering means.

**Patentansprüche**

1. Verfahren zum Testen einer elektronischen Schaltungsanordnung (22), das die folgenden Schritte umfasst:

   Liefern eines Testsignals mit einer vorgegebenen Form an spezielle Signaleingangsmittel der Anordnung;
   Betreiben der Anordnung in einem vorgegebenen Modus;
   Extrahieren eines Ergebnissignale von beabsichtigter Form aus speziellen Signalausgangsmitteln der genannten Anordnung, um das genannte Ergebnissignal anschließend auszuwerten;

   wobei das genannte Verfahren **dadurch gekennzeichnet ist, dass** ein erstes analoges Signal (40) in einen digitalen Bitstrom (44) moduliert wird und der genannte digitale Bitstrom nachfolgenden Filtermitteln (50) zugeführt wird, um durch analoges Herausfiltern des genannten digitalen Bitstroms das genannte Testsignal als ein zweites analoges Signal (52) am Ausgang der genannten Filtermittel zu erzeugen.

2. Verfahren nach Anspruch 1, wobei es sich bei der genannten Modulation um eine Sigma-Delta-Modulation erster oder zweiter Ordnung handelt.

3. Verfahren nach Anspruch 1 oder 2, wobei das genannte Extrahieren einen Schritt der wiederholten Diskriminierung eines Ausgangswellen-Ergebnissignals mit aufeinanderfolgenden Schwellwertpegeln und die anschließende Neuausrichtung von aufeinanderfolgenden Diskriminierungs-Bitfolge-Ergebnissen umfasst, um zu den jeweiligen Zeitpunkten einen Thermometer-Signalcode zu erzeugen.

4. Vorrichtung zur Prüfung einer elektronischen Schaltungsanordnung (22), wobei die genannte Vorrichtung Folgendes umfasst:

   Testsignal-Quellenmittel (2) zum Liefern eines Testsignals mit einer vorgegebenen Form an spezielle Signaleingangsmittel der genannten Anordnung;
   Steuermittel (32, 34) zum Betreiben der Anordnung in einem vorgegebenen Modus;
   Extrahiermittel (30) zum Extrahieren eines Ergebnissignale von beabsichtigter Form aus speziellen Ergebnissignalausgangsmitteln der genannten Anordnung, um das genannte Ergebnissignal anschließend auszuwerten; **dadurch gekennzeichnet, dass** sie über Moduliermittel (42) verfügt, um ein erstes analoges Signal (40) in einen digitalen Bitstrom (44) zu modulieren, und über Filtermittel (50), die von den genannten Moduliermitteln versorgt werden, um durch analoges Herausfiltern des genannten digitalen Bitstroms das genannte Testsignal als ein zweites analoges Signal (52) am Ausgang der genannten Filtermittel zu erzeugen.

5. Vorrichtung nach Anspruch 4, wobei die genannten Testsignal-Quellenmittel über digitale Speichermittel (46) verfügen, um den digitalen Bitstrom zu speichern, wie der durch die genannten Moduliermittel erzeugt wird, und um ihn anschließend den genannten Filtermitteln (50) zuzuführen.

6. Vorrichtung nach Anspruch 4 oder 5, wobei die genannten Moduliermittel vorgesehen sind, um eine Sigma-Delta-Modulation erster oder zweiter Ordnung durchzuführen.

**7.** Vorrichtung nach Anspruch 4, 5 oder 6, und mit Boundary-Scan-Test-Schnittstellenmitteln zur Verbindung mit der genannten elektronischen Schaltungsanordnung.

**8.** Vorrichtung nach einem der Ansprüche 4 bis 7, und vorgesehen, um einen Selbsttest durchzuführen, indem sie über mindestens teilweise eigenständige genannte Testsignal-Quellen- und/oder Auswertungsmittel verfügt.

**9.** Vorrichtung nach einem der Ansprüche 4 bis 8, wobei die genannten Extrahiermittel (30) ein Diskriminierungsmittel umfassen, um ein Ausgangswellen-Ergebnissignal mit aufeinanderfolgenden Schwellwertpegeln zu diskriminieren, und Speichermittel, die durch die genannten Extrahiermittel versorgt werden, um aufeinanderfolgende Diskriminierungs-Bitfolge-Ergebnisse zu speichern, um nach der Neuausrichtung entsprechende Thermometer-Signalcodes zu erzeugen, die jeweils einem Analogsignal zugeordnet sind, das zu einem betreffenden Zeitpunkt ausgegeben wird.

**10.** Elektronische Schaltungsanordnung als ein Ziel zum Ausführen des Verfahrens nach Anspruch 1 und die Folgendes umfasst: Testsignal-Quellenmittel zum Erzeugen eines Testsignals, Testsignal-Eingangsmittel zum Empfangen des Testsignals, Betriebsmitteln, die durch die genannten Testsignal-Eingangsmittel versorgt werden, um in einem vorgegebenen Betriebsmodus das genannte Testsignal so zu verarbeiten, dass ein Ergebnissignal einer bestimmten Form entsteht, und Ergebnissignal-Ausgabemitteln zum Ausgeben des genannten Ergebnissignals zur anschließenden Auswertung, **dadurch gekennzeichnet, dass** die genannten Testsignal-Quellenmittel digitale Speichermittel (46) zum Speichern eines digitalen Bitstroms umfassen, der von einem ersten analogen Signal abgeleitet wurde, und Filtermittel (50), die durch die genannten digitalen Speichermittel versorgt werden, um durch analoges Herausfiltern des genannten digitalen Bitstroms das genannte Testsignal als ein zweites analoges Signal (52) an einem Ausgang der genannten Filtermittel zu erzeugen.

## Revendications

**1.** Procédé pour tester un montage de circuits électroniques (22), ledit procédé comprenant les étapes suivantes :

- fournir un signal d'essai de forme prédéterminée à un moyen d'entrée de signal spécifique du montage;
- faire fonctionner ledit montage dans un mode prédéterminé;
- extraire un signal de résultat de forme prévue du moyen de sortie de signal spécifique dudit montage en vue d'une évaluation subséquente dudit signal de résultat;

ledit procédé étant **caractérisé par** la modulation d'un premier signal analogique (40) en un train de bits numériques (44) et la présentation dudit train de bits numériques à un moyen de filtrage subséquent (50) pour produire par filtrage analogique dudit train de bits numériques ledit signal d'essai comme deuxième signal analogique (52) à une sortie dudit moyen de filtrage.

**2.** Procédé suivant la revendication 1, dans lequel ladite modulation est une modulation sigma delta du premier ou du deuxième ordre.

**3.** Procédé suivant la revendication 1 ou 2, dans lequel ladite extraction comprend l'étape visant à discriminer de manière répétée un signal de résultat d'onde de sortie avec des niveaux de seuil successifs et à réaligner ensuite les résultats de train de bits de discrimination successifs pour générer, à des instants respectifs, un code de signal de thermomètre.

**4.** Appareil pour tester un montage de circuits électroniques (22), ledit appareil comportant :

- un moyen de source de signal d'essai (20) pour fournir un signal d'essai de forme prédéterminée à un moyen d'entrée de signal d'essai spécifique dudit montage;
- un moyen de commande (32,34) pour faire fonctionner ledit montage en un mode prédéterminé;
- un moyen d'extraction (30) pour extraire un signal de résultat d'une forme prévue du moyen de sortie de signal de résultat spécifique dudit montage pour évaluation subséquente dudit signal de résultat,

**caractérisé en ce qu'**il comporte un moyeu de modulation (42) pour moduler un premier signal analogique (40) en un train de bits numériques (44) et un moyen de filtrage (50) alimenté par ledit moyen de modulation pour produire par filtrage analogique dudit train de bits numérique ledit signal d'essai comme deuxième signal analogique (52) à une sortie dudit moyen de filtrage.

5. Appareil suivant la revendication 4, dans lequel ledit moyen de source de signal de test comporte un moyen de stockage numérique (46) pour stocker le train de bits numériques produits par ledit moyen de modulation, et pour le présenter ultérieurement audit moyen de filtrage (50).

6. Appareil suivant la revendication 4 ou 5, dans lequel ledit moyen de modulation est agencé pour exécuter une modulation sigma delta du premier ou du deuxième ordre.

7. Appareil suivant les revendications 4, 5 ou 6, et comportant un moyen d'interface de test série à balayage de limite pour servir d'interface audit montage de circuits électroniques.

8. Appareil suivant l'une quelconque des revendications 4 à 7, agencé pour exécuter un test automatique par le fait qu'il intègre, d'une manière au moins partiellement autonome ladite source de signal d'essai et/ou ledit moyen d'évaluation.

9. Appareil suivant l'une quelconque des revendications 4 à 8, dans lequel ledit moyen d'extraction (30) comprend un moyen de discrimination pour discriminer un signal de résultat d'onde de sortie avec des niveaux de seuil successifs et un moyen de mémoire alimenté par ledit moyeu d'extraction pour stocker des résultats de train de bits de discrimination successifs pour, après réalignement, produite des codes de signaux de thermomètre respectifs associés chacun à un signal analogique fourni à un instant respectif.

10. Montage de circuits électroniques servant de cible pour exécuter un procédé suivant la revendication 1 et comportant un moyen de source de signal d'essai pour générer un signal d'essai, un moyen d'entrée de signal d'essai pour recevoir le signal d'essai, un moyen d'exploitation alimenté par ledit moyen d'entrée de signal d'essai pour, dans un mode d'exploitation prédéterminé, agir sur ledit signal d'essai pour produire un signal de résultat de forme prédéterminée et un moyen de sortie de signal de résultat pour fournir ledit signal de résultat en vue d'une évaluation subséquente, dans lequel ledit moyen de source de signal d'essai comprend un moyen de stockage numérique (46) pour stocker un train de bits numériques dérivé d'un premier signal analogique et un moyen de filtrage (50) alimenté par ledit moyen de stockage numérique pour produire, par filtrage analogique dudit train de bits numériques, ledit signal d'essai comme deuxième signal analogique (52) à une sortie dudit moyen de filtrage.

FIG. 1

FIG.2

A

B

FIG.4

FIG.3

FIG.5

FIG.6